# EUROPEAN PATENT APPLICATION

(11) **EP 3 267 128 A1**
(43) Date of publication of application: **10.01.2018**
(21) Application number: 17180208.5
(22) Date of filing: 07.07.2017
(51) Int. Cl.: F25B 7/00, F25B 21/02

(54) **ELECTROCALORIC COOLING**

(30) Priority: 07.07.2016 US 201615204341
(71) Applicant: Goodrich Corporation, Charlotte, NC 28217-4578 (US)
(72) Inventor: MANTESE, Joseph V., Ellington, CT 06029 (US); ANNAPRAGADA, Subramanyaravi, South Windsor, CT 06074 (US); VERMA, Parmesh, South Windsor, CT 06074 (US); XIE, Wei, East Hartford, CT 06118 (US); EASTMAN, Scott Alan, Glastonbury, CT 06033 (US)
(74) Representative: Hughes, Andrea Michelle

(57) **Abstract**

A cooling system for electrical and optical devices includes an electrocaloric cooler (EEC) (102). A fluid circuit (104) is in thermal communication with the EEC to dump heat from a working fluid of the fluid circuit into the EEC. The system can include a second EEC (118), a second fluid circuit (120) in thermal communication with the second EEC to dump heat from a working fluid of the second fluid circuit into the EEC, and a second heat sink (122) in thermal communication with the second fluid circuit to dump heat into the working fluid of the second fluid circuit. The second EEC, second fluid circuit, and second heat sink can be cascaded with the first EEC, first heat sink, and first fluid circuit wherein the second heat sink is in thermal communication with the first EEC to accept heat therefrom.

## Description

### BACKGROUND OF THE INVENTION

### 1. Field of the Invention

The present disclosure relates to heat transfer, and more particularly to cooling such as used in imaging, and optical chemical sensing systems.

### 2. Description of Related Art

Optical detection systems often utilize cooling systems to control temperature of components such as focal plane arrays (FPA's) or point detectors to improve image quality or otherwise enhance signal to noise ratio. Traditional cooling techniques include using thermoelectric coolers (TEC's) and Stirling Cycle Refrigeration devices. Each of these two types of coolers has tradeoffs. TEC's are traditionally used for applications where cooling is not required below 200 K. However, below that temperature, traditional TEC's operate with poor efficiency because the free carries comprising the conventional thermoelectric semiconductor tend to freeze out and pumping efficiency diminishes rapidly. Stirling Cycle Refrigeration devices are more complex, bulky, and have much higher incidence of failure compared to their TEC counterparts, however they are often used in applications where local cooling below 200K is required.

Such conventional methods and systems are used extensively in the commercial and military purposes; primarily because of the limited number of options for alterative technology. However, there is still a need in the art for improved cooling techniques to reduce size, weight, and power; while simultaneously improving reliability. The present disclosure provides a solution for this need.

### SUMMARY OF THE INVENTION

A cooling system for electrical and optical devices includes an electrocaloric cooler (EEC). A fluid circuit is in thermal communication with the EEC to dump heat from a working fluid of the fluid circuit into the EEC. A heat sink is in thermal communication with the fluid circuit to dump heat into the working fluid.

A pump can be in fluid communication with the fluid circuit to drive working fluid around the fluid circuit to convey heat from the heat sink to the EEC. The EEC can include a series of films configured to allow passage of the working fluid therethrough. A power source can be operatively connected to the EEC to drive electrical field control of the EEC for cooling.

The EEC can be a first EEC, wherein the heat sink is a first heat sink, and wherein the fluid circuit is a first fluid circuit. The system can include a second EEC, a second fluid circuit in thermal communication with the second EEC to dump heat from a working fluid of the second fluid circuit into the second EEC, and a second heat sink in thermal communication with the second fluid circuit to dump heat into the working fluid of the second fluid circuit. The second EEC, second fluid circuit, and second heat sink can be cascaded with the first EEC, first heat sink, and first fluid circuit wherein the second heat sink is in thermal communication with the first EEC to accept heat therefrom.

At least one additional unit can be cascaded with the second fluid circuit, second EEC, and second heat sink, wherein the at least one additional unit includes a respective EEC, fluid circuit, and heat sink. Each respective cascaded fluid circuit and EEC can be configured to operate at a lower temperature range than a nearest neighboring cascaded fluid circuit and EEC. The cascaded fluid circuits and EEC's can be configured to provide cryogenic temperatures at the first heat sink.

A heat producing device can be included, wherein the heat sink, e.g., the first heat sink, is in thermal communication with the heat producing device to accept heat dumped from the heat producing device. The heat producing device can include an electronic device, imaging device, HVAC device, gas phase liquefaction device, or any other suitable heat producing device.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic view of an exemplary embodiment of a cooling system constructed in accordance with the present disclosure, showing the fluid circuit;
Fig. 2 is a schematic view of a portion of the system of Fig. 1, showing the series of films of the electrocaloric cooler (EEC); and
Fig. 3 is a schematic view of an exemplary embodiment of a cooling system constructed in accordance with the present disclosure, showing multiple circuits like that of Fig. 1 cascaded to provide cryogenic cooling.

### DETAILED DESCRIPTION OF THE PREFERRED EMBODIMENTS

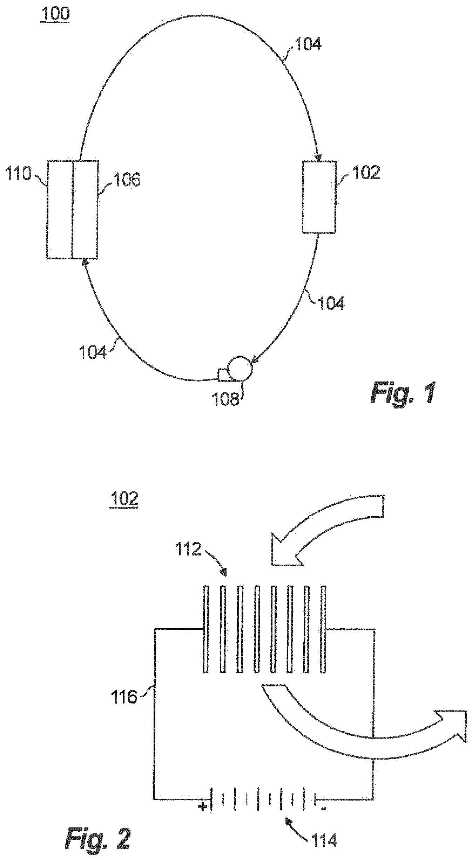

Reference will now be made to the drawings wherein like reference numerals identify similar structural features or aspects of the subject disclosure. For purposes of explanation and illustration, and not limitation, a partial view of an exemplary embodiment of a system in accordance with the disclosure is shown in Fig. 1 and is designated generally by reference character 100. Other embodiments of systems in accordance with the disclosure, or aspects thereof, are provided in Figs. 2-3, as will be described. The systems and methods described herein can be used for cooling electric and electronic components, such as cryogenic cooling for imaging systems.

Cooling system 100 for electrical and optical devices includes an electrocaloric cooler (EEC) 102. A fluid circuit 104 is in thermal communication with the EEC 102 to dump heat from a working fluid of the fluid circuit 104 into the EEC 102. A heat sink 106 is in thermal communication with the fluid circuit 104 to dump heat into the working fluid. A pump 108 is in fluid communication with the fluid circuit 104 to drive working fluid around the fluid circuit 104 to convey heat from the heat sink 106 to the EEC 102.

A heat producing device 110 can be included, wherein the heat sink 106 is in thermal communication with the heat producing device 110 to accept heat dumped from the heat producing device 110. The heat producing device 110 can include any suitable electric or electronic device such as an imaging device, an HVAC device, or any other type of heat producing device such as a gas phase liquefaction device.

Referring now to Fig. 2, the EEC 102 includes a series of spaced apart films 112 configured to allow passage of the working fluid therethrough, e.g., through the spaces between the films 112, as indicated schematically in Fig. 2 by the large arrows. The films 112 can be configured for regenerative or single shot EEC cooling. A power source 114 is operatively connected to the EEC 102, e.g. forming a circuit 116, to drive electrical field control of the EEC 102 for cooling.

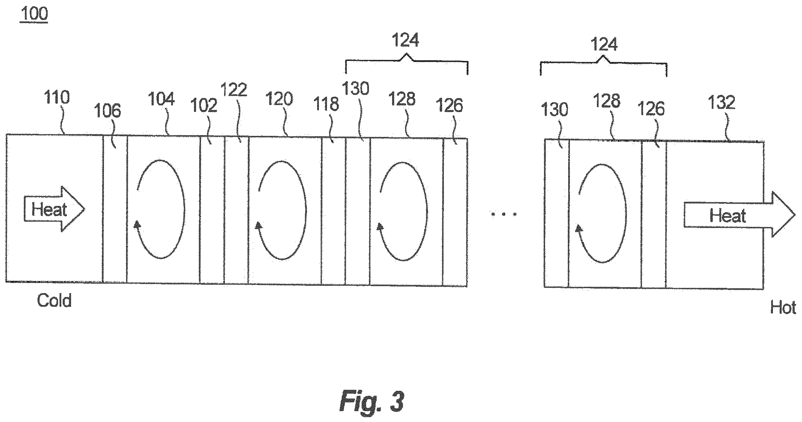

With reference now to Fig. 3, heat producing device 110, heat sink 106, fluid circuit 104, and EEC 102 are shown schematically. The system 100 can include a second EEC 118, a second fluid circuit 120 in thermal communication with the second EEC 118 to dump heat from a working fluid of the second fluid circuit 120 into the second EEC 118. A second heat sink 122 is connected in thermal communication with the second fluid circuit 120 to dump heat into the working fluid of the second fluid circuit 120. The second EEC 118, second fluid circuit 120, and second heat sink 122 can be cascaded with the first EEC 120, first heat sink 106, and first fluid circuit 104, i.e. with the second heat sink 122 in thermal communication with the first EEC 102 to accept heat therefrom.

Additional unit 124 can be cascaded with the second fluid circuit 120, second EEC 118, and second heat sink 122, wherein each additional unit 124 includes a respective EEC 126, fluid circuit 128, and heat sink. Each respective cascaded fluid circuit 128 and EEC 126 can be configured to operate at a lower temperature range than a nearest neighboring cascaded fluid circuit and EEC, as indicated in Fig. 3 by the heat arrows indicating heat flow from cold to hot. The cascaded fluid circuits and EEC's can be configured to provide cryogenic temperatures at the first heat sink 106, e.g., for cooling heat producing device 110, wherein heat is ultimately dumbed as a system heat sink 132. This level of cooling can readily lend itself to mid-wavelength infrared (MWIR) and long-wavelength infrared (LWIR) imaging devices, for example. The ellipsis in Fig. 3 indicates that any suitable number of cascaded EEC units can be included. With the correct selection of working fluids and EEC configurations in the cascade, it is possible to lower a system temperature to near absolute zero due to the fact that the EEC materials do not require free charge to operate as do TEC's. As an example, the EEC's can be formed from materials comprised of Ba1-xSrxTiO3, where the operating temperature drops continuous with increase x. At x=0, the operating temperature is ~120°C, where as x→1 the operating temperature drops to ~4K.

The methods and systems of the present disclosure, as described above and shown in the drawings, provide for cooling systems with superior properties including lower operating temperatures that traditional TEC's and with less weight and bulkiness than traditional Stirling Cycle Refrigeration devices or other vapor compression like devices. While the apparatus and methods of the subject disclosure have been shown and described with reference to preferred embodiments, those skilled in the art will readily appreciate that changes and/or modifications may be made thereto without departing from the scope of the invention as defined by the claims.

## Claims

1. A cooling system device comprising:
a heat sink (106) configured to be in thermal communication with a device;
an electrocaloric cooler, EEC (102); and
a fluid circuit(104) in thermal communication with the EEC and the heat sink, wherein the fluid circuit is configured to transfer heat from the heat sink to the EEC.

2. A system as recited in claim 1, further comprising a pump (108) in fluid communication with the fluid circuit to move working fluid around the fluid circuit to convey heat from the heat sink to the EEC.

3. A system as recited in claim 1or 2, wherein the EEC (102) is a first EEC, wherein the heat sink is a first heat sink (106), and wherein the fluid circuit (104) is a first fluid circuit and further comprising:
a second EEC (118);
a second fluid circuit (120) in thermal communication with the second EEC to dump heat from a working fluid of the second fluid circuit into the second EEC; and
a second heat sink (122) in thermal communication with the second fluid circuit to dump heat into the working fluid of the second fluid circuit, wherein the second EEC, second fluid circuit, and second heat sink are cascaded with the first EEC, first heat sink, and first fluid circuit wherein the second heat sink is in thermal communication with the first EEC to accept heat therefrom.

4. A system as recited in claim 3, further comprising at least one additional unit cascaded with the second fluid circuit, second EEC, and second heat sink, wherein the at least one additional unit includes a respective EEC, fluid circuit, and heat sink.

5. A system as recited in claim 4, wherein each respective cascaded fluid circuit and EEC are configured to operate at a lower temperature range than a nearest neighboring cascaded fluid circuit and EEC.

6. A system as recited in claim 5, wherein the cascaded fluid circuits and EEC's are configured to provide cryogenic temperatures at the first heat sink.

7. A system as recited in any preceding claim, wherein the EEC includes a series of films (112) configured to allow passage of the working fluid therethrough.

8. A system as recited in any preceding claim, further comprising a power source (114) operatively connected to the EEC to drive electrical field control of the EEC for cooling.

9. A system comprising:
a heat producing device (110); and
a cooling system device as claimed in any preceding claim;
the fluid circuit (104) in thermal communication with the EEC (102) to dump heat from a working fluid of the fluid circuit into the EEC; and
the heat sink (106) in thermal communication with the fluid circuit to dump heat into the working fluid, wherein the heat sink is in thermal communication with the heat producing device to accept heat dumped from the heat producing device.

10. A system as recited in claim 9, wherein the heat producing device (110) includes at least one of an electronic device, an imaging device, gas phase liquefaction device, or an HVAC device.
